# EUROPEAN PATENT APPLICATION

(11) **EP 1 923 950 A1**
(43) Date of publication of application: **21.05.2008**
(21) Application number: 06425785.0
(22) Date of filing: 17.11.2006
(51) Int. Cl.: H01P 5/107

(54) **SMT enabled microwave package with waveguide interface**

(71) Applicant: Siemens S.p.A., 20126 Milano (IT)
(72) Inventor: Bonato, Paolo, 20156 Milano (IT); Buoli, Carlo, 200060 Bussero (IT); Cifelli, Antonio, 20060 Gessate (MI) (IT); Fusaroli, Stefano, 20040 Cavenago Brianza (MI) (IT); Morgia, Fabio, 20139 Milano (IT); Negri, Luigi, 26866 Sant' Angelo Lodigiano (IT); Trombetta, Antonella, 20133 Milano (IT); Turillo, Tommaso, 20063 Cernusco Sul Naviglio (MI) (IT)
(74) Representative: Giustini, Delio

(57) **Abstract**

A microwave package for surface mount technology (SMT) integrates in its multilayer structure a waveguide interface comprising a microstrip to rectangular waveguide transition. The transition includes a patch at the end of a launching microstrip faced to a slot which is dug into a copper plate 0.5 mm thick, constituting the ground plane for the topmost microstrip layout and thermal sink for MMICs supported on it. The slot acts as an iris allowing propagation of fundamental TE₁₀ mode into a waveguide interface including a parallelepipedal cavity dug into the thickness of copper laminate under and around it starting from the bottom of the multilayer. The metallized cavity extends until the ground plane at the bottom with a cross-section preferably equally dimensioned as the external waveguide. The metallization of the cavity walls joins the ground plane at the bottom without breaking the continuity. Metallization of ground plane continues along the very narrow side walls determined by the thickness of multilayer. A metal lid is soldered along a metallized perimetrical frame on the upper layer. The lid is internally carved to obtain a cavity faced to the transition for reflecting back to the slot the power irradiated upwards. The ground plane on the bottom face includes the mouth of the internal waveguide tract, and the contacting beams for an external layout of the supporting PCB. The package is ready to be soldered to a PCB including in its turn a very short waveguide tract in its thickness between the mouth of the package and a metallic waveguide dug into the supporting mechanics (fig.10)

## Description

### FIELD OF THE INVENTION

The present invention relates to the field of SMT components, and more precisely to a SMT-enabled microwave package with waveguide interface.

### BACKGROUND ART

Before illustrating the prior art in the outlined technical sector, it is useful to anticipate some characteristics of the invention because they are essential to a microwave package to be declared suitable for surface mount technology (SMT). They are:
1. Flat base with laid down a ground metallization plane and all soldering pads for interconnecting the external layout reported on the back isolated from the ground plane.
2. An internal microstrip-to-waveguide transition (and vice-versa) including a microstrip used as a probe for irradiating from its end a microwave signal towards the waveguide or, dually, for intercepting the microwave signal into the waveguide and conveying it along the microstrip.
3. An internal microwave cavity between the transition and the external waveguide (mechanical) opened on the ground plane.
4. A completely shielded case to prevent radiation losses; the case shall have a conductive lid reflecting back the electromagnetic power irradiated by the probe at the work frequency.
5. A good thermal dissipation.
6. Being cost-effective also for operating frequencies above 30 GHz.

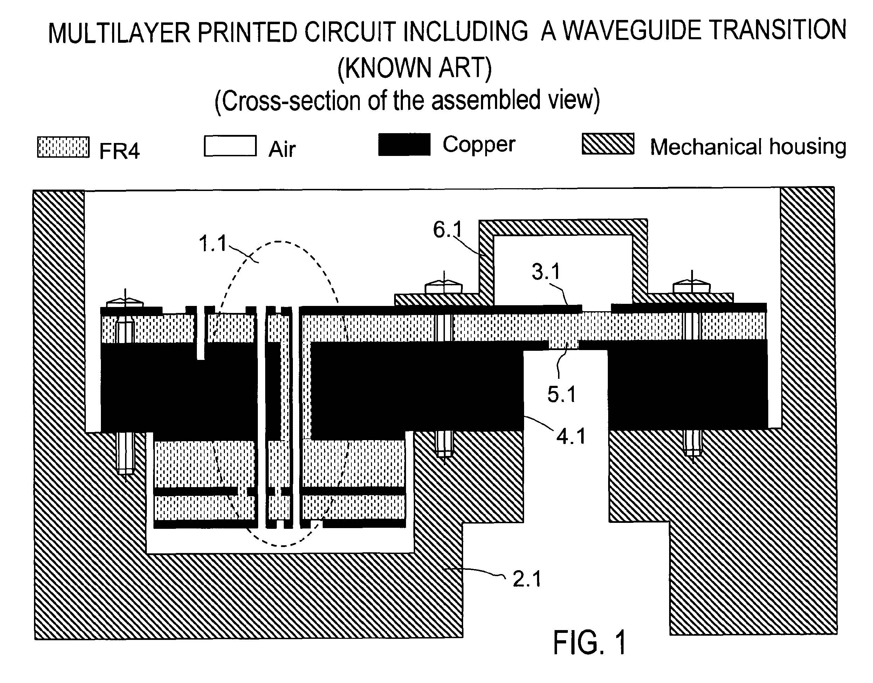

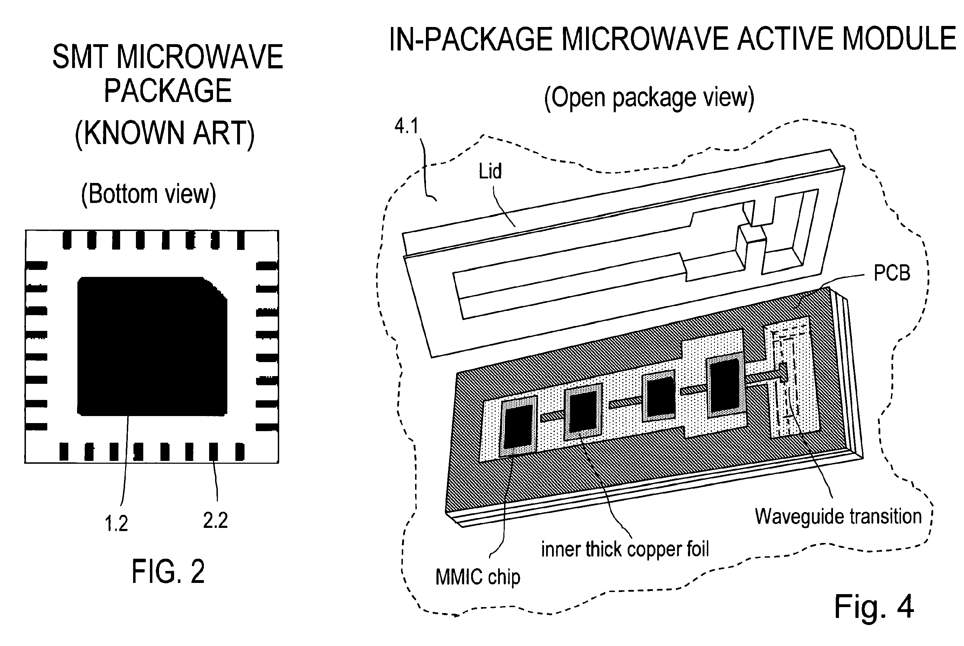

Fulfilling the six conditions simultaneously is hard. Some known typologies of planar microwave circuits are mentioned now as examples of failing in this task. These circuits might be approximately subdivided in the following three categories:
a) Planar microwave circuits including a waveguide input/output port in correspondence of a flange connectable to the edge of the waveguide (the flange is screwed to the mechanics) to prolong the waveguide inside the package. A significant example matching this art is disclosed in EP 02425349.4 patent application filed by the same Applicant. This category of devices fail to satisfy point 3 above because the flange is unsuitable for SMT. Category a) is detailed in **fig.1.**
b) SMT microwave packages without a waveguide input/output port. Belong to this category all commercial packages having pads on the bottom to connect the external PCB layout also for input/output microwave signals. Category b) is detailed in **fig.2.**
c) Microwave packages potentially for SMT but with some limitations especially at the highest frequencies due to some expedient in their realization. An example is disclosed in patent application EP 0874415 A2 (Kyocera). Category c) is detailed in **fig.3a** and **3b**.

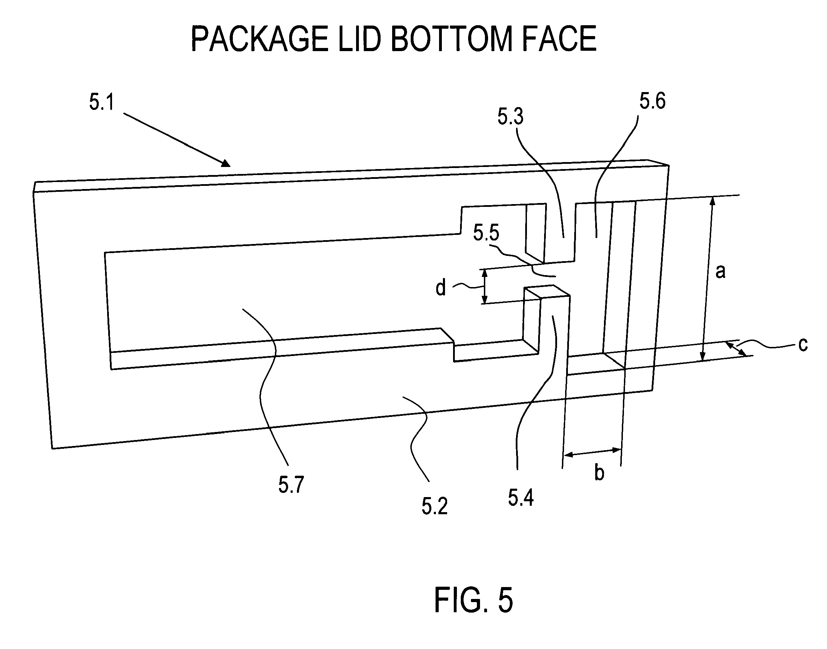

**Fig.1** (fig.5c of EP 02425349.4) shows the cross-section of a PCB including a microstrip to waveguide transition assembled to the mechanics. With reference to the figure, we see a PCB multilayer 1.1 screwed to the mechanics housing the end of a rectangular metallic waveguide 2.1. The multilayer includes three FR4 dielectric layers interleaved with four metallic layers crossed by through holes. The upper metallic layout includes a microstrip 3.1, the second metallic layer is a thick copper plate 4.1, third and fourth metallic layers include connecting lines and ground plane. A slot 5.1 is opened in the thick metal plate 4.1 faced to the end of the microstrip 3.1, the slot is enlarged for near all thickness of layer 4.1. The multilayer 1.1 is milled under the metal plate 4.1 in a whole zone around the enlarged slot 5.1: the bare zone constitutes a flange for rigid connection of the edge of waveguide 2.1. The end of microstrip 3.1 irradiates electromagnetic power towards the waveguide 2.1 through the slot 5.1, and in opposite direction towards a metallic lid 6.1 screwed to the edge of waveguide 2.1 through the multilayer 1.1. The end of the microstrip 3.1 with the first FR4 layer below and the faced slot 5.1 constitute a microstrip to waveguide transition integrated in the multilayer 1.1. Metallic lid 6.1 is a backshort used as a reflector to prevent propagation on the air. It is quite evident from the assembling of fig.1 its inadequacy to be used for SMT. This is mainly due to the rectangular opening inside the multilayer 1.1 in correspondence of the flange, which subtracts surface of contact to a possible PCB mounting the transition forcing to introduce the end of waveguide 2.1 into the opening and screwing the edge of waveguide to the lid 6.1 penetrating through the multilayer 1.1. To be surface mounting a device shall be only picked-and-placed and soldered without any other mechanical handling.

**Fig.2** shows the bottom side of a microwave square package of the PQF (Plastic Quad Flat) type. This is a small surface mount package with leads on the bottom, characterized by a large centre metal pad 1.2 with small thermal resistance and peripheral leads 2.2 on the sides. Other SM packages, instead of rectangular leads, have a ball grid array of contacts on the bottom. This category of flat SMT packages has a frequency operation range up to 30 GHz, after which the parasitic effects of contacts introduce excessive losses.

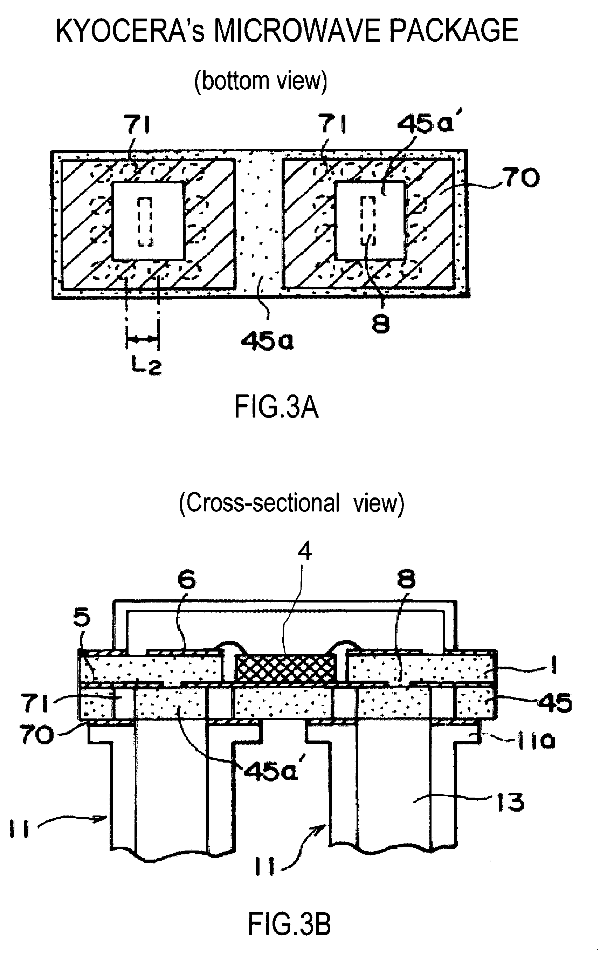

**Fig.3A** (Kyocera, FIG.21B) shows the bottom side of a microwave package not expressly mentioned for SMT applications but, from the figure, should seem possible soldering the structure to a PCB carrying mechanical interfaces to waveguides. In the cited application term "package" includes the multilayer circuit. In the figure we see a dielectric substrate 45a supporting a frame-like metal layer 70 shaped into two separate frames around respective windows 45a' without metallization 70 and with a dashed slot 8 visible in the centre. A number of via-hole conductors 71 are sketched along the inner peripheral edges of frame-like metal layer 70. A distance L2 among the via-holes is set to a length not larger than one- fourth the wavelength of the transmission signals in order to effectively prevent the leakage of electromagnetic signals from the dielectric substrate 45a.

**Fig.3B** shows a cross-section of the complete package where the true meaning of the sketched elements is clarified and additional layers are visible to form a multilayer. More in particular, a metallic layer 5 constituting a ground plane is laid down on the other face of dielectric substrate 45a; another dielectric layer 1 is superimposed to layer 5; and another metallic layout including two conduct lines 6 (microstrips) is the uppermost layer. Both slots 8 are opened into the ground plane 5 in proximity of the irradiating ends of the conduct lines 6 which have the other ends soldered to the beams of a microwave active element 4. An upper lid is soldered to the first layout to enclose device 4 and the irradiating ends of lines 6. Two rectangular waveguides 11 have a flange portion on the edges in contact with respective metal frames 70, the slot 8 formed in the ground plane 5 is located at the centre of the dielectric space 45a' closed by the via-hole conductors 71, that work as a false conductor wall. The electromagnetic signals irradiated by the end of conductor lines 6 cross in sequence: dielectric layer 1, slots 8, dielectric layer 45a', and the air space internal to the waveguides 11. The dielectric block 45a (45a') has a thickness which is equal to one- fourth the wavelength of the transmission signals in order to match the impedance of slots 8 to that of the waveguides 11.

The main drawback of this implementation is the lack of continuity between the internal wall of waveguides 11 and the metal plane 5 delimiting the irradiating slots 8. In fact, the ground contact between these two reference points is not direct but transported by the crown of metallized via-holes 71. This solution is equivalent to a "quasi waveguide" extension inside the dielectric space, in analogy with term "quasi coaxial" cable proposed by Kyocera's itself in a coaxial connection between different ground planes exploiting metallized through-holes instead of the external conductor. The "quasi waveguide" does not satisfy the requirement of a perfect shielding, so that it should at most usable until the λ/4 bound doesn't limit the manufacturing of metallized via-holes excessively. At the highest operating frequencies this bound is unbearable, so as the other bound on the λ/4 thickness of dielectric 45a. The non perfect shielding is cause of unwanted propagation inside dielectric layer 45a. The non perfect impedance matching between slot 8 and waveguide 11, due to non-optimal electrical thickness of dielectric layer 45a' inside the crown of metallized holes 71, is cause of undesirable signal reflections and consequent losses. Also at the operating frequencies there are the following losses: dielectric losses due to the presence of body 45a' instead of air inside the "quasi waveguide", radiation losses due to inductive effects of the waveguide walls, and resistive losses inside the metallized holes 11.

### OBJECT OF THE INVENTION

The main object of the present invention is that to overcome all limitations highlighted for either the microwave circuit-on-board (COB) or packages of the prior art and indicate a microwave package suitable to be surface mounted and soldered to a PCB integrating an interface towards the waveguide.

Other object of the invention is that to indicate a method for manufacturing a microwave package having the features of above.

It is useful to clarify that as a rule a microwave package is like a small case for including microwave circuits and components (MMICs included). In this optic the package is a particular type of case that is not neutral in respect of its content because it shall carry out some functions as far as thermal dissipation, shielding, and input/output RF and service signals are concerned. The package, once is closed with all its components inside takes the name of the function it has been designed for, e.g.: amplifier, transmitter, receiver, etc.

### SUMMARY AND ADVANTAGES OF THE INVENTION

The invention achieves said object by providing a microwave package including:
- a predetermined circuit layout on a first dielectric layer having a conducting line with a free end,
- a subsequent metal plate with a slot opposite to the free end of the conducting line, said free end acting as a probe coupled to the slot electromagnetically,
- at least a subsequent second dielectric layer supporting a metallization extending on the bottom surface as a ground plane;
- an opening extending perpendicularly from a mouth open in the ground plane to reach the metal plate with said slot at the centre;
- said opening having a cross-section substantially equally dimensioned as the cross-section of the internal cavity of a waveguide to be interfaced at said mouth;
- an uniform metallization in continuity with the ground plane on the surface delimiting the volume of said opening internally to the multilayer structure with the exception of said slot;
- a lid faced to said slot including a first conductive hollow part nearly λ/4 depth at the working frequency, as disclosed in claim 1.

Additional features of the present invention which are believed to be novel are set forth with particularity in the appended claims.

According to an aspect of the invention the multilayer includes moderately high loss substrates as FR4 or similar.

According to a variant of the invention, the metal plate is extended beyond the package side walls, for example with two opposite fins acting as thermal radiators for incrementing heat dissipation of the inner active components. Suitability for surface mounting is held by the variant without any changes in the supporting printed circuit board. A further increment on thermal dissipation can be obtained when the fins contact a metal body; in such a case the suitability for surface mounting is held on condition that the printed circuit board has two windows faced to the fins of the package, so as to allow respective metal extensions of the mechanics to protrude inside and contact the fins.

Another object of invention is a PCB for mounting the microwave package described in claim 1, the PCB including a metallized opening having a cross-section preferably equally dimensioned as the mouth at the waveguide interface of said package, but this is not mandatory.

Another object of invention is an assembly for interfacing the microwave package described in claim 1 to the external waveguide, the assembly includes said PCB fixedly connected to a metallic base embodying the waveguide, in such a way that the open end of the waveguide are opposite to one end of the metallized opening crossing the PCB.

Another object of invention is a microwave circuit module including the microwave package of claim 1 soldered to the aforesaid assembly, in such a way that the other end of the PCB's metallized opening is opposite to the mouth at the package's waveguide interface.

Another object of invention is a method for manufacturing the microwave package described in claim 1.

The new SMT package has the following advantages:
• Easy to develop by means of the universally used PCB manufacturing technologies.
• In the same package, single receiver/transmitter or all the receiving and transmitting functions can be embedded, in order to realize in one component an entire microwave unit up to 60 GHz.
• Very low-cost because of using moderately high loss substrates as FR4 or similar.
• Good thermal dissipation factor due to thick inner copper foil insert.
• Easy test and handling.
• Very good reliability.
• Small impact for changing MW component relating only to the package modification without motherboard reworking.
• Microstrip-waveguide transition embedded on the package: only an opening is needed to cross the motherboard and connect the waveguide.
• Despite the loss factor, the insertion loss of the microstrip-to-waveguide transition is contained below 0.5 dB; the transition is broadband and the distance to the device shall be short.
• Allows motherboard standard process without any RF tuning.
• Allows motherboard may keep the same production-code unchanged in large bandwidth applications limited only to waveguide size.
• Easier flux project because the package is like a complete front-end component.

In conclusion, the package of the invention allows a better performance, compared to a traditional package components line-up.

### BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:
- **fig.1**, already described, indicates a microwave multilayer printed circuit of the prior art connected to a waveguide;
- **fig.2**, already described, indicates a SMT microwave package of the prior art without interface to a waveguide;
- **figures 3A** and **3B**, already described, indicate a bottom and a cross-sectional view, respectively, of a microwave package of the prior art integrating an interface to a waveguide;
- **fig.4** indicates a perspective view of an in-package microwave active module shown in open package position, which makes use of the SMT package of the present invention;
- **fig.5** indicates a perspective view of the dug lid of the package of fig.4;
- **figures 6** and **7** indicate the top and bottom view, respectively, of the package of **fig.4**;
- **fig.8A** indicates a longitudinal cross-section of the package along axis A-A of fig.6;
- **fig.8B** indicates a variant of the package of fig.8A;
- **fig.9** indicates the soldering metallized shape reproducing the bottom view of fig.7 on the upper side of a PCB mounting the package of fig.4;
- **fig.10** completes the sectional view of fig.8A with the supporting PCB and the waveguide;
- **fig.11** indicates two curves of the S₁₁ and S₂₁ waveguide transition parameters versus frequency;
- **fig.12** indicates the sequential steps of the manufacturing method of the package of **fig.8A**;
- **fig.13** indicates a multilayer with multiple instances of the printed circuit layout of the package of fig.8A or 8B.

### DETAILED DESCRIPTION OF AN EMBODIMENT OF THE INVENTION

As a description rule, same elements in the drawings are referenced by the same labels, and the elements represented in the figures are not a scaled reproduction of the original ones.

With reference to **fig.4** we see a microwave package 4.1 including a metal lid, a multilayer printed circuit miniboard, and four MMICs (Monolithic Microwave Integrated Circuits). The lid is in open position to shows the package's content. A shielding metallization around the narrow lateral surface of multilayer is not shown in the figure. The package's multilayer let us foresee an inner thick copper foil under the MMICs, and a waveguide transition in the right side.

With reference to **fig.5** we see a lid 5.1 turned to show the bottom surface in contact with the multilayer. The bottom surface is carved to obtain:
- a perimetrical conductive frame 5.2 protruding from an internal top wall;
- two opposite rectangular fingers 5.3 and 5.4 departing from the conductive frame 5.2 which let open an interposed window 5.5;
- a rectangular microwave cavity 5.6 faced to the waveguide transition area, delimited by the frame 5.7 and fingers 5.3 and 5.4 at one side;
- a conductive hollow part 5.7 delimited by the conductive frame 5.7 and fingers 5.3 and 5.4 at the other side in respect of cavity 5.6. An electromagnetic absorber can be placed inside the hollow part 5.7.

The rectangular resonant cavity 5.6 has length a and height b substantially equal to the corresponding dimensions of the cross-section of the external rectangular waveguide. The width c of the rectangular resonant cavity 5.6 is λ/4 at the working frequency. The distance d between fingers 5.3 and 5.4 is lower than λ/2 at the working frequency in order to prevent unwanted signal propagation between the two hollow parts 5.6 and 5.7. The loss factor of the substrate, works as a microwave absorber; it avoids spur signals propagation and makes less critical the width of the package, which usually is linked to the waveguide cut-off frequency.

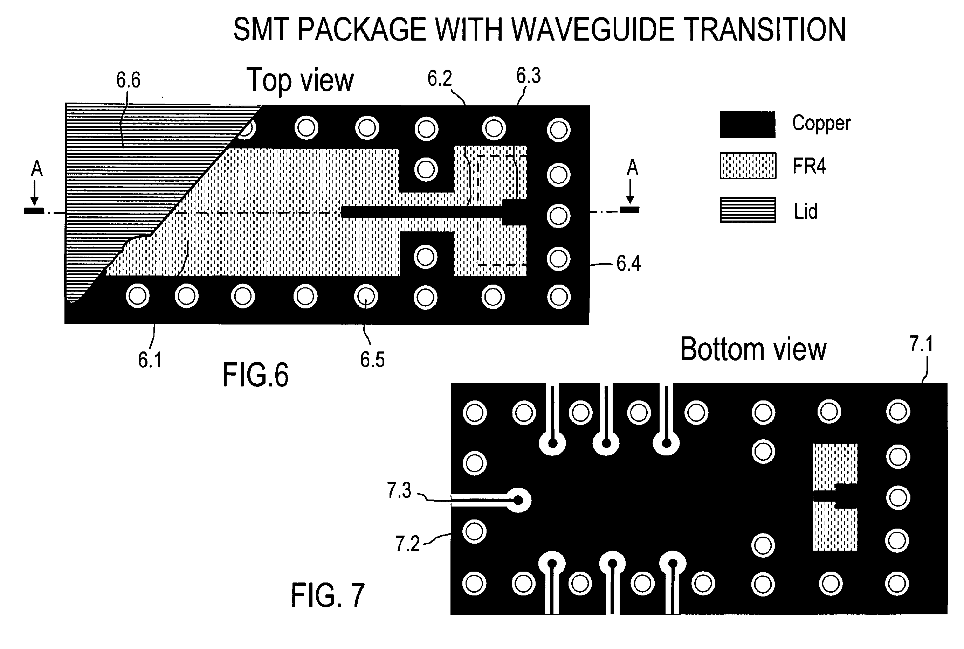

In **fig.6** the upper surface of the package of fig. 4 is depicted with the lid almost completely removed to show a dielectric layer 6.1 at the top of a multilayer. The dielectric 6.1 support a metallic layout including a microstrip 6.2 terminating with an enlarged square-end 63 (patch). The whole surface of dielectric layer 6.1 is encircled by a perimetrical metallization frame 6.4 having a shape identical to the relief of the internal edge 5.2 (fig.5) of lid 6.6 (shown in partial view). The free end of microstrip 6.2, corresponding to unconnected patch 6.3, enters a bare rectangular window placed on the same perpendicular axis of an external rectangular waveguide (not represented) connected to the bottom of the package. Inside the rectangular window is indicated in dashed line a slot of layering below. Except the rectangular window, the remaining part of layer 6.1 is reserved to the circuits (not indicated). Along the perimetrical metallized frame 6.4 there is a row of metallized through holes regularly spaced to each other, whose main purpose is that to connect the upper metallization frame 6.4 to a ground plane at the bottom of multilayer. A subset of through holes is used to interconnect the conducting layouts on internal layers. The terminal tract of microstrip 6.2 with its patch 6.3 constitute an electromagnetic radiofrequency probe for irradiating the microwave signal travelling on microstrip 6.2 in the surrounding confined space.

In **fig.7** the bottom surface of the package of fig.4 is represented. The figure highlights a ground plane 7.1 having the same geometrical arrangement of through holes 7.2 and dielectric window as the preceding fig.6. This is obvious because the holes are drilled in the whole thickness of the multilayer and the rectangular window shall communicate with the waveguide. The window in figure is lower than the cross-section of waveguide, it corresponds to a slot opened in metallic layer under the launching microstrip. Nearby the metallized through holes some soldering pads 7.3 are provisioned to interconnect the external layouts on the supporting PCB. Pads 7.3 are mainly devoted to connect biasing voltage/current sources to MMICs inside the package and transport continuous or intermediate frequency signals needed to the operation, while for the input/output radiofrequency signal in the range of microwave an internal transition towards the waveguide is used. From the electromagnetic point of view the transition, that will be detailed in the successive figures, it is quite similar to the one illustrated in fig.1 and disclosed in the cited patent application. The interface to the external waveguide provided by the package in subject, diversely from the flange connection of fig.1, is a simple rectangular mouth accessible by the ground plane 7.1. This type of interface allows the package to be soldered according to either two modalities: a) to a similar mouth of a very short waveguide tract obtained trough the thickness of a PCB multilayer interposed between the package and the waveguide; or b) directly to the end of the external waveguide. Obviously, the first modality is the only one in line with SMT, so it constitutes a preferable use of the package.

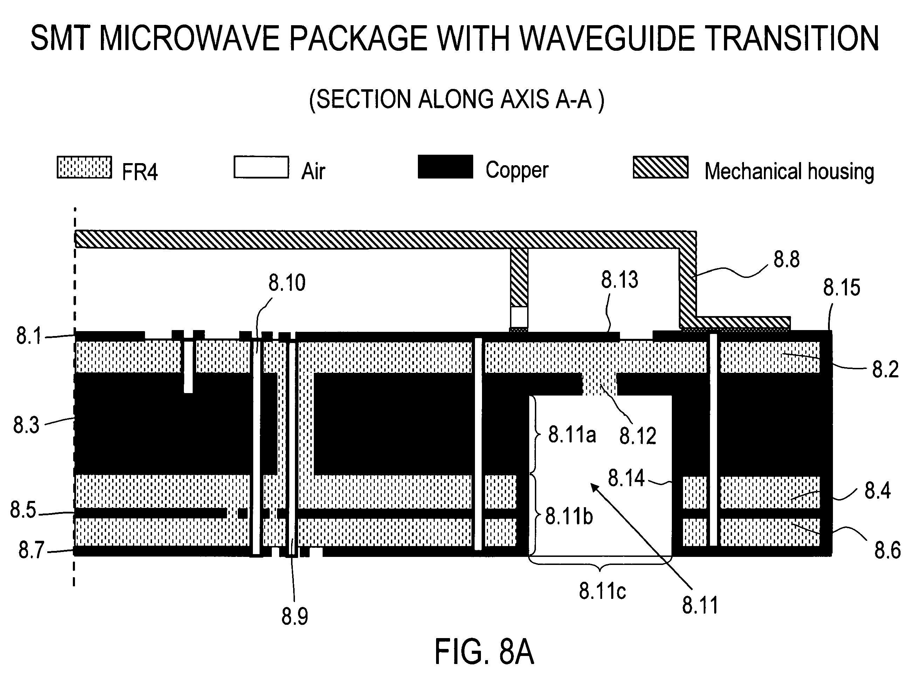

**Fig.8A** shows a longitudinal section of the package along the axis A-A of fig.6. With reference to the figure we see a multilayer structure comprising three dielectric layers 8.2, 8.4, and 8.6 with interposed two metallic layers 8.3 and 8.5, plus a topmost circuital layer 8.1 and a lowest ground plane 8.7. Top-down order of the layers is following: 8.1 - 8.7. Without limitation, the package of fig.8A has been used to implement a 30 GHz prototype transmitter with output transition in waveguide. The microstrip circuit is prevalently on layer 8.1. The three dielectric layers are of the low-cost fibreglass-reinforced plastic (FR4) material characterized by moderately high power losses as the substrates currently used in PCBs. Nevertheless more expensive material with lower power losses, e.g. Teflon, can be used. Dielectric layer 8.2 has a thickness of 0.1 mm, so as to guarantee the propagation of the only quasi-TEM mode of the microstrips up to 80 GHz. There are not bounds for the thickness of dielectric layers 8.4, and 8.6 between them are laid down other secondary connections, nevertheless it is advisable to hold them thin, e.g. 0.1 mm, to reduce the thermal resistance of metallized through holes which connect all ground planes.

The three conducting metallic layers 8.1, 8,5, and 8.7 have a thickness of 0.017 mm. The second metallic layer 8.3 is a copper plate with a thickness of 0.5 mm, considered optimal to simplify the manufacturing of the package and to provide thermal dispersion on the whole surface. Besides, the thick plate 8.3 adds up stiffness to the multilayer structure and provides a solid base for the anchorage of MMICs in direct contact with it, so as to increase the thermal dispersion. On the top of multilayer a lid 8.8 is soldered to a corresponding metallized perimetrical frame on layer 8.1. Some metallized holes 8.9 and 8.10 go through the whole thickness of the multilayer and either contact the ground plane 8.7 or some pads isolated from the ground plane used to interconnect the external layout of the supporting PCB. Starting from the bottom of the structure, the layers 8.7, 8.6, 8.5, 8.4, and a great deal of the copper plate 8.3 are dug and removed so as to obtain a parallelepipedal opening 8.11 shaped as exactly the cavity of the external waveguide, i.e. with equal cross-section. The top wall of the opening 8.11 includes a central rectangular slot 8.12 filled up with the same FR4 material of the superimposed layer 8.12. Slot 8.12 is faced to the end of a microstrip 8.13 of the first layer 8.1 terminating with a patch. The walls of the rectangular opening 8.11, just after it is dug into the multilayer, are constituted by rings with different electrical properties at their surface, to say, an upper segment 811a has conductive walls, while a subsequent segment 8.11b has walls prevalently dielectric. The walls of two segments 811 a and 8.11 b of the opening 8.11 are covered by a homogeneous metallization 8.14 in continuity with the metallization of the ground plane 8.7, the latter being further extended to cover all side walls of the multilayer. As a consequence, the opening 8.11 behaves as a microwave cavity similar to a rectangular waveguide tract inside the multilayer, shielded from external interference and noise. The waveguide tract 8.11 has a mouth 8.11 c surrounded by the ground plane 8.7 for coupling an external waveguide, electromagnetically. Contacting beams for an external layout on PCB are provided in islands of the ground plane 8.7. The package is so ready to be picked-and-placed and soldered to a PCB according to known surface mount techniques (SMT). Sn-Pb or similar alloys are used in the soldering operation. The package is completely surrounded by a continuous metallization 8.7 and 8.15 joined to the metallic lid 8.8, so it is shielded from external interference.

In operation, from the end of microstrip 8.13 the microwave signal is irradiated downwards to the slot 8.12 and upwards to the cavity 5.6 (fig.5) dg inside the thickness of lid 8.8. Cavity 5.6 is λ/4 depth in the working band, so that the short circuit at the end wall is reported as an open circuit on the plane of microstrip 8.13, and the upward signal is reflected back to slot 8.12 (electrical iris) without mismatching the microstrip 8.13. The launching microstrip patch is dimensioned in order to provide a resistive impedance of 50 Ω inside the whole operating frequency band. The downward signal crosses the slot 8.12 and enters into the shielded waveguide tract 8.11 directed to the external waveguide. Slot 8.12 is dimensioned in order to match the 50 Ω impedance of the microstrip patch 8.13 to the impedance of the coupled waveguide tract 8.11 (and the waveguide). The depth of slot 8.12 is much lower than λ/4 in the working band, in such a way that this slot behaves as an iris able to excite TE₁₀ mode into the waveguide tract 8.11; moreover power loss due to the filing material is completely negligible. The microwave signal travelling on microstrip 8.13 is forced to change of 90° the direction of its propagation in correspondence of the aforementioned elements 8.13, 8.2, 8.12, 8.11, and 8.14 that, considered together, constitute a microstrip to waveguide transition completely inside the package without any mechanical element (e.g. flange) is needed at the waveguide interface. The microstrip to waveguide transition transforms the "quasi-TEM" propagation mode of the microstrip 8.13 into TE₁₀ mode of the rectangular waveguide tract 8.11. The reciprocal behaviour of the transitions is known. A significant role in the transition is played by the thick copper plate 8.3 which simultaneously provides: a) ground plane for the launching microstrip 8.13; b) an iris 8.12 for matching to the waveguide; and c) more than half the height of the internal waveguide tract 8.11.

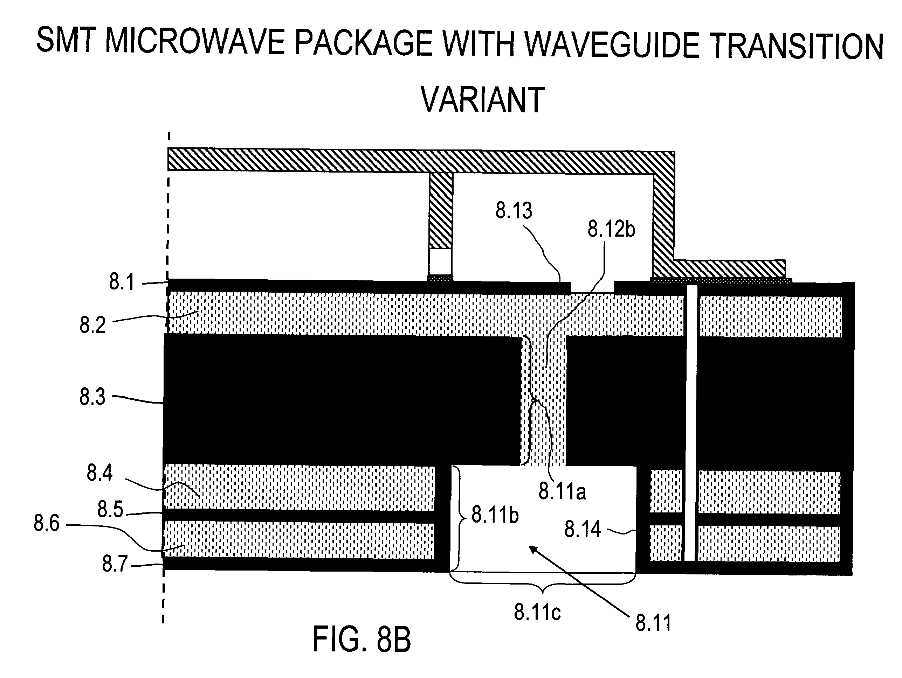

**Fig.8B** shows a variant of the invention which differs from the embodiment of **fig.8A** by the only depth of the slot milled in copper plate 8.3. Differently from the preceding slot 8.12, a slot 8.12b is now crossing completely the copper plate 8.3 without changing its width. Being 0.5 mm only the thickness of copper plate 8.3, that is nearly 1/5 of λ/4 of working frequency, its iris behaviour is still valid. This variant introduces a slight simplification of the manufacturing process.

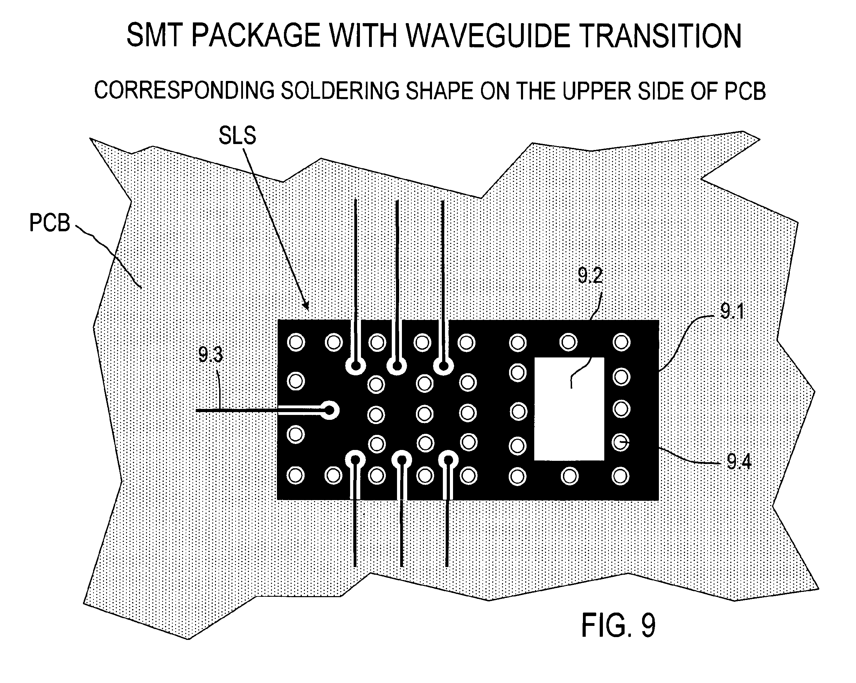

**Fig.9** shows the upper face of a multilayered PCB where a soldering shape SLS of the only zone predisposed to mount the package of fig.8A or 8B is outlined. The soldering shape SLS resembles the bottom surface of the package reported in fig.7. With reference to the figure, we see a ground plane 9.1 with a rectangular opening 9.2 crossing the whole multilayered PCB shaped and dimensioned as the mouth 8.11 c (fig.8A/8B). The internal walls of said opening determined by the thickness of multilayer are metallized and the metallization is joined to the ground planes at the two sides. The opening 9.2 behaves as a very short waveguide tract inside the PCB. The ground plane also includes connecting lines 9.3 directed to respective pads, that will be soldered to the metallized through holes terminating on the bottom surface of the package. Ground plane 9.1 also includes some metallized through holes 9.4 that connect it to all underneath ground planes of PCB, especially the last.

In operation, the special PCB of fig.9 is used for mounting the package of fig.8A/8B, in such a way that the mouth 8.11c is opposite to the mouth 9.2 and both aligned on a common axis perpendicular to the layers passing for the centre of the two mouths. The complete configuration will be illustrated in the successive figure.

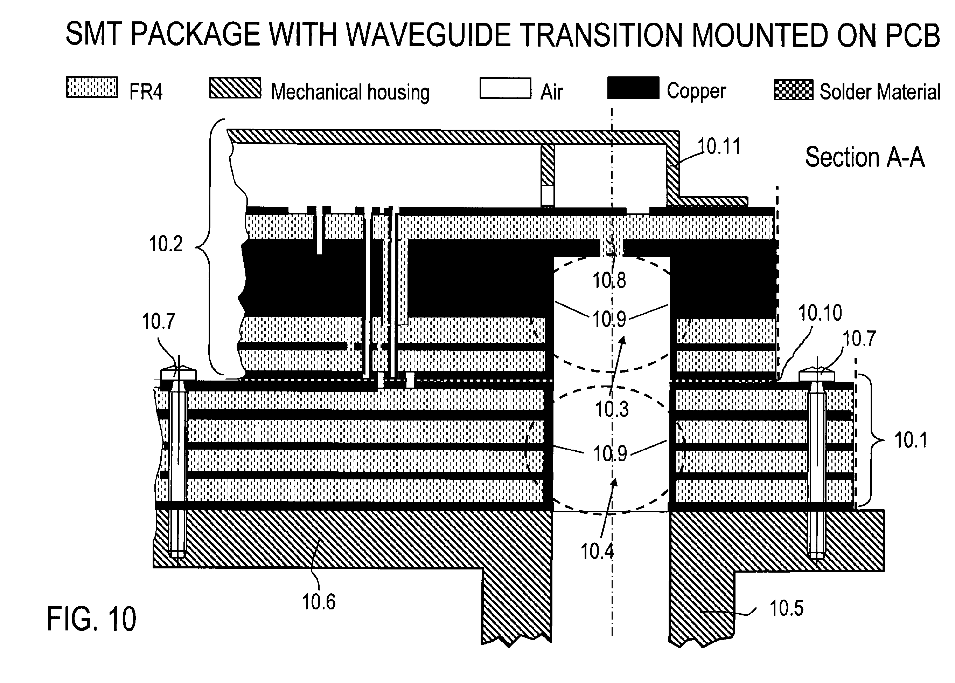

**Fig.10** represents an assembly of the package of fig.8A mounted on the PCB of fig.9 coupled to a waveguide. With reference to the figure, we see a multilayer 10.1 constituting the PCB bearing the package 10.2 on it, the package is positioned exactly upon the corresponding soldering zone illustrated in the preceding fig.9. The configuration of the final assembly shows two contiguous waveguide tracts 10.3 and 10.4, respectively obtained insight the package and the PCB, in their turn contiguous to the cavity of a waveguide 10.5. The latter is dug in a metallic base plate 10.6 fixed by screws 10.7 to the PCB. All on-air microwave paths, included the cavity carved on the thickness of lid 10.11, are aligned along the same longitudinal axis perpendicular to the PCB. It can be noticed from the figure that, differently from the quasi-waveguide transition of prior art, the space other than slot 10.8 is completely filled with air and completely delimited by a metallization 10.9 in continuity with the ground plane. Furthermore, the metallization 10.9 continues inside the PCB 10.1 up to the waveguide 10.5. At the interface between the two waveguide tracts 10.3 and 10.4 the continuity of metallization 10.19 is secured by soldering the faced ground planes together with interposed soldering material 10.10 electrically conductive.

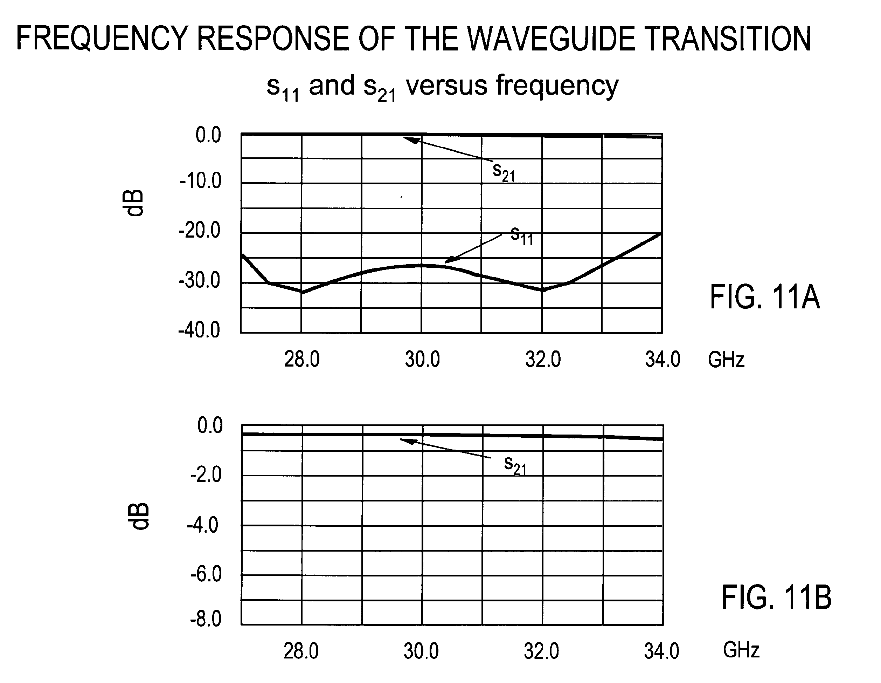

With reference to **fig.11A** the scattering matrix parameters **s₁₁** and **s₂₁** of the internal transition embodied as described are represented versus frequency. The two curves have been obtained by known simulation techniques and confirmed by relevant measures. Parameter **s**₁₁ represents return loss at the mouth of cavity 8.11 (fig.8A/8B) open in the ground plane, while **s**₂₁ is the power transferred to a matched load. **Fig.6b** enlarges the detail of the parameter **s**₂₁. From the Figures is clearly visible that nearly 7 GHz bandwidth, from 27 to 34 GHz, is achievable with return losses lower than 20 dB and in-band attenuation lower than 0.5 dB. The 0.4 dB insertion loss is mainly due to the FR4 substrate, using other substrates based on Teflon the losses can be reduced to 0.2 dB, nevertheless it is useful to underline that the FR4 has the advantage to dampen unwanted electromagnetic propagation modes along the circuit.

The maximum working frequency of the package can be extended well beyond 30 GHz; in fact, there are not inherent limitations in the proposed structure which provides an authentic waveguide internal to the package. Conversely, the prior art either provides a "quasi-waveguide" intrinsically limited in frequency or a simple flange unsuitable for SMT. The package in subject can be easily extended to the use of waveguides with cross-section other than rectangular. Rectangular waveguides are preferable in respect of circular or elliptical waveguides, because easier to handle and dig in the metal body. The package can be also extended to dielectric substrates with the same mechanical characteristics of the FR4 but lower dielectric losses, such as for instance substrates known in the art with the commercial name of ROGER^{™}.

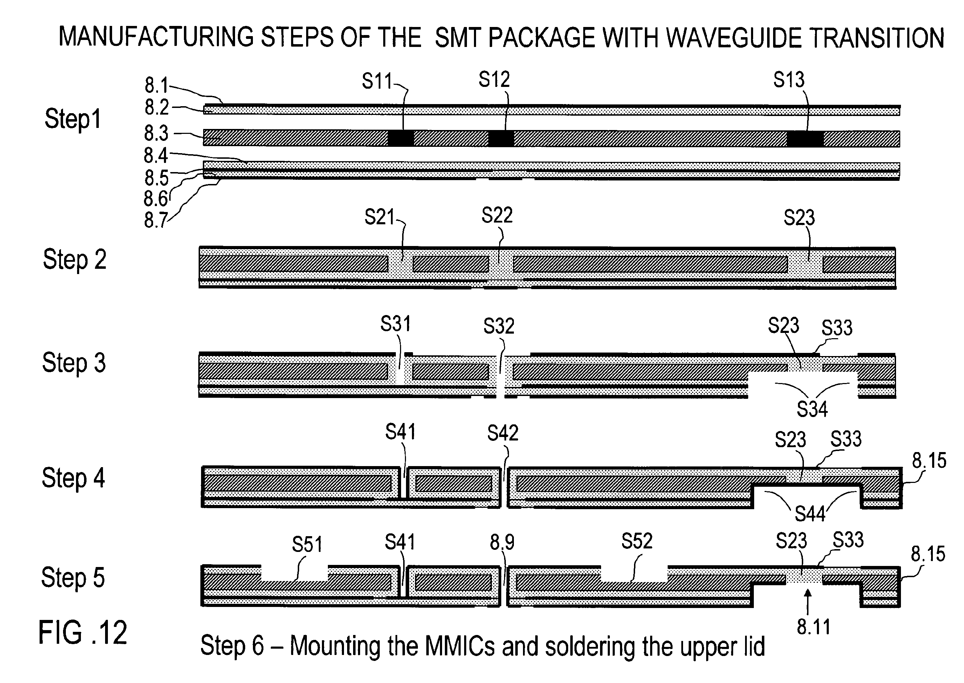

In **fig.12** the sequential steps of the manufacturing process leading to the final package sectioned in **fig.8A** are summarized. Considered by itself each step is known from the technology of manufacturing multilayered PCBs, nevertheless the particular combination of steps allows to achieve a novel type of package as said above. The illustration of the method is supported by illustrating the modifications gradually impressed on a seven-layer multilayer 8.1 to 8.7 indicated at step 1 in exploded view.
Step 1. The first step summarizes a number of preceding operations bringing back to obtain internal circuital layouts on layers 8.1 and 8.5 and the ground plane 8.7 with its input/output pads isolated from the ground. Two holes S11, S12 are drilled in thick metallic plate 8.3 and a rectangular slot S13 is obtained. These steps are also performed in the previously cited invention.
Step 2. The various layers 8.1 to 8.7 are pressed in a hot press for a predetermined time necessary to polymerize the FR4 material which fills up the previous holes and the slot of metallic plate 8.3, obtaining two filled holes S21, S22 and a filed slot S23. After cooling to the environmental temperature the various layers result stuck together to form a very compact multilayer. These steps are also performed in the previously cited invention.
Step 3. The following substeps are performed: 3.a) holes of the type S22 are drilled again through the whole thickness of the multilayer obtaining through holes S32 with lower diameter; 3.b) holes of the type S21 are drilled until reaching layer 8.5, obtaining blind holes S31 with lower diameter; 3.c) metallization is removed around the free end of a microstrip S33 obtaining a dielectric window visible in fig.6; 3.d) the four last layers 8.7 to 8.4 and part of the copper plate 8.3 are dug and removed starting from a rectangular area of the bottom surface centred under slot S23, obtaining a parallelepipedal opening S34 with a cross-section substantially equal to that of an external waveguide (S34 is the unmetallized cavity 8.11).
Step 4. Bored holes and the walls of cavity S34 are metallized by chemical and galvanic process, obtaining metallized internal blind holes of the type S41, metallized through holes of the type S42, completely metallized cavity S44, and the metallization 8.15 along the very narrow side walls determined by the thickness of multilayer. Metallization of holes S42, cavity S44, and the narrow side walls don't break the continuity with the ground plane.
Step 5. During the fifth step the metallization of the cavity S44 is etched and removed in correspondence of iris S23, so that the cavity 8.11 is completed. If necessary, windows are dug in the top of the structure to lay bare the metal plate 8.3, obtaining locations (S51, S52) for mounting the MMICs.
Step 6. During the sixth step the MMICs are placed into their locations and soldered to the upper layout; then the lid is soldered upon the complete structure and the packaged active device is ready.

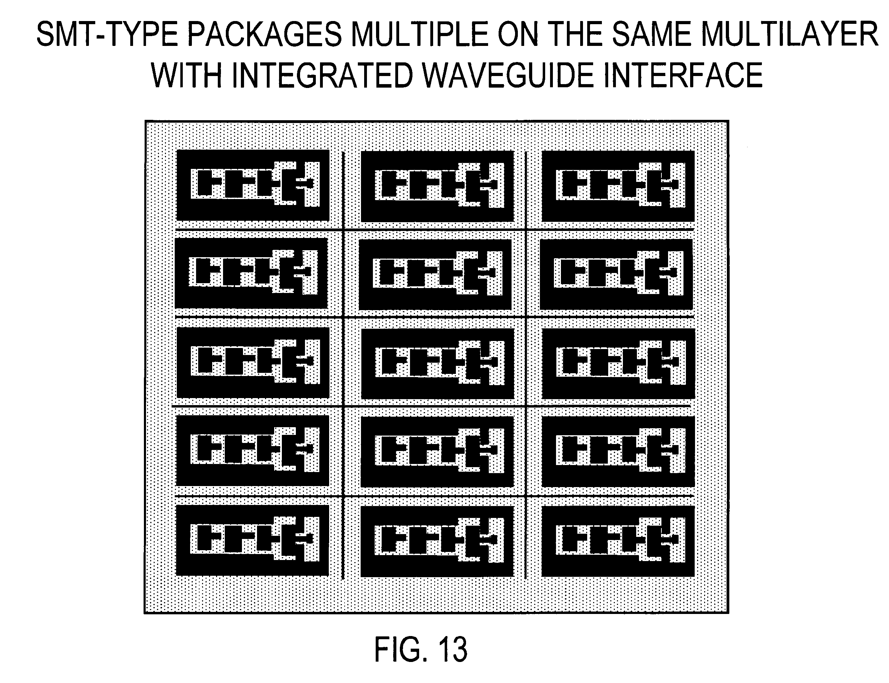

The above steps 1-6 can be executed for obtaining a single package or a plurality of packages on the same multilayer, as illustrated in fig.13.

On the basis of the above description some changes may be introduced in the exemplary embodiment by the skilled in the art without departing from the scope of the appended claims.

## Claims

1. Microwave package (10.2) including:
- a multilayer printed circuit structure (8.1 - 8.7) providing:
- a predetermined circuit layout (8.1) on a first dielectric substrate (8.2) including a conducting line (8.13) with a free end,
- a metal plate (8.3) with a slot (8.12) placed oppositely to the free end of the conducting line acting as a probe coupled to the slot electromagnetically;
- a second dielectric substrate (8.4) supporting a metallization (8.7) extending on the bottom surface of multilayer as a ground plane;
- an interface to an external waveguide (10.5) coupled to said slot (8.12);
- a lid (5.1, 8.8) including a first conductive hollow part (5.6) nearly λ/4 depth at the working frequency, faced to said slot (8.12),
**characterized in that** the interface towards the external waveguide (10.5) includes:
- an opening (8.11) extending perpendicularly inside the multilayer (8.4 - 8.7) from a mouth (8.11 c) open in the ground plane (8.7) to reach the metal plate (8.3) with the slot (8.12, 8.12b) at the centre;
- said opening (8.11) having a cross-section substantially equally dimensioned as the cross-section of the internal cavity of a waveguide (10.5) to be interfaced at said mouth (8.11c);
- an uniform metallization (8.14) in continuity with the ground plane (8.7) on the surface delimiting the volume of said opening (8.11) internally to the multilayer with the exception of said slot (8.12, 8.12b).

2. The microwave package of claim 1, **characterized in that** said slot (8.12, 8.12b) having a depth significantly lesser than λ/4 at the working frequency.

3. The microwave package of claim 1, **characterized in that** said slot (8.12) having a depth lower than the thickness of the metal plate (8.3).

4. The microwave package of any claim from 1 to 3, **characterized in that** further includes a metallization (8.15) from the ground plane (8.7) covering the side walls determined by the thickness of multilayer (8.1 - 8.7).

5. The microwave package of any claim from 1 to 4, **characterized in that** said lid (5.1) includes a second conductive hollow part (5.7) faced to said circuit layout on the first layer (8.1).

6. The microwave package of any claim from 1 to 5, **characterized in that** said lid (5.1) includes a perimetrical metal frame (5.2) in relief.

7. The microwave package of claim 6, **characterized in that** said perimetrical metal frame (5.2) of the lid (5.1) includes two opposite fingers (5.3, 5.4) delimiting said hollow parts (5.6, 5.7).

8. The microwave package of claim 7, **characterized in that** the two opposite fingers (5.3, 5.4) are separated by a distance (5.5) lower than λ/2 at the working frequency.

9. The microwave package of any claim from 1 to 8, **characterized in that** said first layer (8.1) includes a perimetrical metallized frame (6.4) in contact with ground plane (8.7) by means of metallized through holes (6.5).

10. The microwave package of claim 9, **characterized in that** said perimetrical metallization frame (6.4) is shaped as said metal frame in relief (5.2) of the lid (5.1) and the two frames are soldered together.

11. The microwave package of any claim from 1 to 10, **characterized in that** said bottom layer (8.7) also includes contacting beams (7.3) isolated from the ground plane for interconnecting an external circuital layout on a printed circuit board (10.1) mounting the package (10.2).

12. The microwave package of any claim from 1 to 11, **characterized in that** said first dielectric layer (8.2) includes one or more niches for the insertion of active microwave devices in thermal contact with said metal plate (8.3) and in electrical contact with said circuit layout (8.1).

13. The microwave package of claim 12, **characterized in that** said metal plate (8.3) is extended beyond the package side walls for incrementing heat dissipation.

14. The microwave package of any claim from 1 to 13, **characterized in that** said opening (8.11) internal to the multilayer has rectangular cross-section like the external waveguide.

15. A printed circuit board (10.1) for surface mounting the microwave package of claim 1, **characterized in that** includes a metallized opening (9.2) to be coupled to the mouth (8.11c) at the waveguide interface of said package (10.2).

16. The printed circuit board (10.1) of claim 15, **characterized in that** further includes a metallized soldering shape (SLS) substantially identical to the metallization shape existing on the bottom face (8.7) of sad package (10.2).

17. An assembly for interfacing the microwave package (10.2) of claim 1 to the external waveguide (10.5), **characterized in that** includes the printed circuit board (10.1) of claim 15, fixedly connected to a metallic base (10.6) including said waveguide (10.5), in such a way that the open end of the waveguide (10.5) is opposite to one end of said metallized opening (9.2) of the printed circuit board (10.1).

18. A microwave circuit module **characterized in that** includes the microwave package of claim 1 soldered to the assembly of claim 17, in such a way that said mouth (8.11 c) at the waveguide interface of the package (10.2) is opposite to the other end of the metallized opening (9.2) of said printed circuit board (10.1)

19. Method for manufacturing a microwave package (10.2) including the following steps:
• providing a printed circuit multilayered structure (8.1 - 8.7) by means of:
• impressing a predetermined circuit layout (8.1) on a first dielectric substrate (8.2) having at least a conducting line (8.13) with a free end;
• milling a slot (8.12) inside a metal plate (8.3) placed downstream the first dielectric substrate in a way that the slot is opposite to the free end of the conducting line acting as probe coupled to said slot electromagnetically;
• laid down a metallization extending on the bottom surface of multilayer as a ground plane (8.7) on at least a second dielectric substrate (8.5) placed downstream the metal plate (8.3);
**characterized in that** further including the steps of:
• removing all layer's material (8.4 - 8.7) beyond said slot (S23) starting from an area of the bottom surface centred under said slot for obtaining an opening perpendicular to the bottom surface having a cross-section substantially equally dimensioned as the cross-section of the internal cavity of a waveguide to be interfaced;
• metallizing the surface delimiting the volume said opening (S44) internally to the multilayer with the exception of said slot S23) without breaking the continuity with the ground plane (8.7);
• removing the metallization on top wall of the metallized opening (S44) in correspondence of said slot (S23), obtaining in this way a waveguide tract inside the multilayer having a mouth (8.11 c) in the ground plane (8.7) for interfacing to the external waveguide (10.5).

20. The method of claim 19, **characterized in that** further including the step of soldering a hollow lid (5.1, 8.8) to a perimetrical metallized frame (6.4) of the upper layer (8.1).

21. The method of claim 19 or 20, **characterized in that** further includes the steps of providing contacting beams (7.3) isolated from the ground plane for interconnecting an external circuital layout on a printed circuit board (10.1) mounting the package (10.2).

22. The method of any claim from 19 to 21, **characterized in that** further includes the steps of:
• milling one or more openings into said first dielectric layer (8.2);
• introducing into said openings active microwave devices in thermal contact with said metal plate (8.3) and in electrical contact with said circuit layout.

23. The method of any claim from 19 to 22, **characterized in that** further includes the steps of:
• providing a printed circuit board (10.1) including a metallized opening (9.2) with cross-section substantially equally dimensioned as the mouth (8.11c) at the waveguide interface of said microwave package (10.2);
• fixedly connecting a metallic base (10.6) including the waveguide (10.5) to said printed circuit board (10.1), in such a way that the open end of the waveguide (10.5) is opposite to one end of said metallized opening (9.2) of the printed circuit board (10.1);
• soldering said microwave package (10.2) to said printed circuit board (10.1) in such a way that its mouth (8.11 c) at the waveguide interface is opposite to the other end of the metallized opening (9.2) of said printed circuit board (10.1).
